# EUROPEAN PATENT SPECIFICATION

(11) **EP 4 170 002 B1**
(45) Date of publication and mention of the grant of the patent: **24.06.2026**
(21) Application number: 21829035.1
(22) Date of filing: 10.06.2021
(51) Int. Cl.: C09K 11/61, C09K 11/62

(54) **THERMAL EVAPORATION METHOD FOR A THALLIUM-DOPED LOW-DIMENSIONAL PEROVSKITE-STRUCTURED METAL HALIDE MICROCRYSTALLINE SCINTILLATION THIN FILM**
THERMISCHES VERDAMPFUNGSVERFAHREN FÜR EINEN THALLIUM-DOTIERTEN NIEDRIGDIMENSIONALEN PEROWSKIT-STRUKTURIERTEN METALLHALOGENID-MIKROKRISTALLINEN SZINTILLATIONS-DÜNNSCHICHTFILM
MÉTHODE D'ÉVAPORATION THERMIQUE POUR UN FILM MINCE SCINTILLANT MICROCRISTALLIN D'HALOGÉNURE MÉTALLIQUE STRUCTURÉ EN PÉROVSKITE DOPÉ AU THALLIUM À FAIBLE DIMENSION

(30) Priority: 22.06.2020 CN 202010573954; 25.04.2021 CN 202110446361
(43) Date of publication of application: 26.04.2023
(73) Proprietor: Shanghai Institute of Ceramics, Chinese Academy of Sciences, Shanghai 200050 (CN)
(72) Inventor: WU, Yuntao, Shanghai 200050 (CN); CHENG, Shuangliang, Shanghai 200050 (CN); WANG, Qian, Shanghai 200050 (CN); SHI, Jian, Shanghai 200050 (CN); LI, Huanying, Shanghai 200050 (CN); REN, Guohao, Shanghai 200050 (CN)
(74) Representative: Leinweber & Zimmermann
(86) International application number: PCT/CN2021/099440
(87) International publication number: WO 2021/259074

(56) References cited:
- CN-A- 109 943 322
- CN-A- 109 991 649
- US-A1- 2013 015 357
- US-A1- 2013 327 945
- US-A1- 2014 264 044
- US-A1- 2015 034 841
- LIAN LINYUAN, ZHENG MOYAN, ZHANG WEIZHUO, YIN LIXIAO, DU XINYUAN, ZHANG PENG, ZHANG XIUWEN, GAO JIANBO, ZHANG DAOLI, GAO LIANG, NI: "Efficient and Reabsorption-Free Radioluminescence in Cs3Cu2I5 Nanocrystals with Self-Trapped Excitons", ADVANCED SCIENCE, vol. 7, no. 11, 1 June 2020 (2020-06-01), pages 1 - 9, XP055883366, ISSN: 2198-3844, DOI: 10.1002/advs.202000195

## Description

### TECHNICAL FIELD

The present invention relates to a thermal evaporation method for a thallium-doped low-dimensional perovskite-structured metal halide microcrystalline scintillation thin film, which belong to the technical field of scintillation materials or lead-free perovskite films.

### BACKGROUND

A scintillator is a material that can convert high-energy rays or particles into visible light or ultraviolet light, and has been widely used in the field of radiation detection. With the continuous improvement of the performance requirements of radiation detection materials in application fields such as homeland security, nuclear medical imaging, and high-energy physics, it is urgent to develop a novel high-performance scintillator.

At present, thallium-doped sodium iodide (NaI:Tl⁺) is a main scintillator used in the field of security inspection internationally. As a widely used commercial scintillation material, such a material has the advantages of high light output (about 40,000 photons/MeV) and low cost, but it has poor energy resolution (about 7% at 662 keV), which limits its application in high-resolution nuclide detection and is prone to deliquesce in air, requiring encapsulation before use.

In order to overcome these disadvantages, many novel scintillators have been developed internationally in recent years, and among them, the main scintillators with outstanding properties are cerium-doped lanthanum bromide (LaBr₃:Ce³⁺) and europium-doped strontium iodide (SrI₂:Eu²⁺). Both materials can achieve a high energy resolution of 2.6% at 662 keV, while both have higher light output than NaI:Tl. However, the LaBr₃:Ce material has a radioactive background of ¹³⁸La, which affects its performance in identifying weak radiation sources; while the SrI₂:Eu material has a strong self-absorption effect, the scintillation property thereof will be significantly decreased when the crystal size is larger. In addition, similar to NaI:Tl, both materials have strong deliquescence and are extremely unstable in the atmospheric environment, greatly increasing the preparation cost and application difficulty.

The aforementioned scintillation materials all have the disadvantage of deliquescence in the air, which is common in halide scintillators. Due to this disadvantage, halide scintillation crystals usually need to be tightly encapsulated before use, which has a great impact on the cost of material storage and use. At present, the non- (or weakly) deliquescent halide scintillator with relatively wide application is mainly thallium-doped cesium iodide (CsI:Tl⁺). This material has a high light output, equivalent to that of NaI:Tl, and is inexpensive, but its long afterglow limits its use in high-resolution imaging. The CsI:Tl crystal also has the problem of non-uniformity of luminescence. This is because Tl⁺ ions are non-uniformly distributed throughout the crystal due to the segregation of components, resulting in a non-uniform scintillation property of the crystal. This disadvantage is common to all doped luminescent scintillation crystals, and will inevitably decrease the final energy resolution of materials.

Moreover, in recent years, perovskite-structured materials have become a subject of research interest in the field of scintillation materials because of their excellent optical and electrical properties. They usually have unique characteristics in light absorption and photoluminescence, such as suitable and adjustable direct bandgap, low-temperature processability, high absorption coefficient, long carrier diffusion distance, high carrier mobility and low defect density, and have shown tremendous application potential in photoelectric detectors and other fields, as well as a certain application prospect in the field of radiation detection, such as security inspection and medical imaging. Low-dimensional perovskite-structured halide materials with the characteristic of confined exciton luminescence have the advantages of large Stokes shift and high fluorescence quantum efficiency. Some of them have shown certain X-ray detection performance, but still cannot completely surpass the existing X-ray detection materials. Therefore, it is urgent to develop a novel low-dimensional perovskite-structured scintillation thin film material with high light yield, high quantum efficiency and low afterglow, which is of great significance for the leap-forward improvement of the performance of X-ray imaging detectors.

US 2015/034841A1 discloses a scintillator plate comprising a Thallium-doped Cs₃Cu₂I₅ film produced using a traditional heating vapor-deposition method, i.e., vaporizing the raw power (CsI and CuI) in a vacuum chamber. US 2015/034841A1 deals primarily with conventional alkali halide scintillators like Cs₃Cu₂I₅ which is a simple binary halide, not a complex perovskite-structured compound. Although US 2015/034841A1 mentions using an activator of thallium iodide as a raw power, what taught by US 2015/034841A1 is till forming scintillator films by conventional evaporation of a host with an activator either premixed or co-introduced.

CN 109991649A discloses a method for preparing AₓB_{y}X_{z} inorganic scintillator film using a close-spaced sublimation technique. However, the close-spaced sublimation technique is also not applicable for preparing a thallium doped low-dimensional perovskite-structured metal halide microcrystalline scintillation film.

### SUMMARY

In view of the aforementioned problems and demands in the prior art, the present invention is intended to provide a thermal evaporation method for thallium-doped low-dimensional perovskite-structured metal halide microcrystalline scintillation thin film as defined in claim 1. The general formulas of the compositions of the low-dimensional perovskite-structured metal halide are (A_{1-a-b}A'ₐTl_{d})(B_{1-c}B'_{c})₂(X_{1-d}X'_{d})₃, (A_{1-a-b}A'ₐTl_{b})₂(B_{1-c}B'_{c})(X_{1-d}X'_{d})₃ or (A_{1-a-b}A'ₐTl_{d})₃(B_{1-c}B'_{c})₂(X_{1-d}X'_{d})₅; wherein A and A' are at least one of Li, Na, K, Rb, Cs and In; B and B' are at least one of Cu and Ag; X and X' are F, Cl, Br and I; and a is greater than or equal to 0 and less than 1, b is greater than 0 and less than or equal to 1, c is greater than or equal to 0 and less than or equal to 1, and d is greater than or equal to 0 and less than or equal to 1; and wherein the X-ray excited luminescence of the thallium-doped low-dimensional perovskite-structured metal halide microcrystalline scintillation thin film is 350 nm to 1200 nm; the thermal evaporation method comprising: placing a substrate into a vacuum coating device; loading coating material into an evaporation boat with a corresponding volume; controlling the vacuum degree and temperature of the vacuum coating device; and starting a coating procedure; wherien the coating material of the thallium-doped low-dimensional perovskite-structured microcrystalline scintillation thin film is a dual-source coating material; the dual-source coating material is a synthesized thallium-doped low-dimensional perovskite-structured compound and thallium halide; and when the coating material is loaded into the evaporation boat with the corresponding volume, an evaporation boat containing bead-like thallium halide is added to evaporate synchronously with the thallium-doped low-dimensional perovskite-structured compound; and wherein the mass ratio of the thallium-doped low-dimensional perovskite-structured compound to thallium halide is 99.99:0.01 to 90:10. The thallium-doped low-dimensional perovskite-structured metal halide microcrystalline scintillation thin film has the advantages of high energy resolution, high light output, non-deliquescence, high uniformity, and low afterglow, etc., and can be widely used in the field of radiation detection.

Preferably, the general formula of the compositions of the low-dimensional perovskite-structured metal halide is (A_{1-a-b}A'ₐTl_{b})₃(B_{1-c}B'_{c})₂(X_{1-d}X'_{d})₅; and A is Cs; B is Cu; X is I; a ,c, and d are equal to 0; and b is greater than 0 and less than or equal to 0.1.

Preferably, the vacuum coating device is vacuumized until the vacuum degree is lower than 10⁻² Pa, and the substrate is heated to 20 °C to 300 °C. After the vacuum degree and the temperature of the substrate are stable, the coating procedure is started, and the coating raw material is heated to a molten state until the evaporation is completed.

Preferably, wherein when the vacuum degree and the temperature of the substrate become stable, the coating procedure is started, and the coating material is heated to a molten state until the evaporation is completed.

### Beneficial Effects:

Compared with CsI:Tl, the thallium-doped low-dimensional perovskite-structured microcrystalline thin film provided by the present invention has the advantages of high scintillation detection efficiency, high light output, adjustable luminescent wavelength, non-deliquescence, low afterglow, no self-absorption, etc., is expected to obtain higher radiation detection imaging quality, can be used for detecting X-rays and neutrons, and has important application prospects in the fields of medical imaging, security inspection, industrial testing, etc.

### BRIEF DESCRIPTION OF DRAWINGS

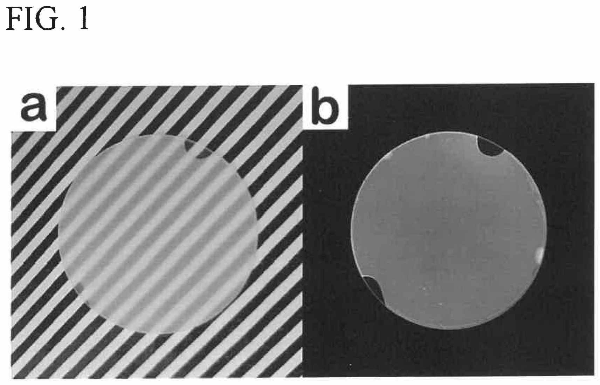

Panel a of FIG. 1 shows a photo of a sample of a microcrystalline thin film obtained in Example 1 under the irradiation of natural light, and panel b of FIG. 1 shows a photo of the sample of the microcrystalline thin film obtained in Example 1 under ultraviolet light irradiation;
FIG. 2 shows an absorption spectrum of the microcrystalline thin film obtained in Example 1;
Panel a of FIG. 3 shows a fluorescence spectrum of the microcrystalline thin film obtained in Example 1 under excitation at 300 nm, and panel b of FIG. 3 shows a fluorescence spectrum of the microcrystalline thin film obtained in Example 1 under excitation at 335 nm;
FIG. 4 shows fluorescence decay times of the two emission peaks (shown in FIG. 3) of the microcrystalline thin film obtained in Example 1;
FIG. 5 shows an X-ray excited emission spectrum of the microcrystalline thin film obtained in Example 1;
FIG. 6 shows an X-ray excited emission spectrum of the microcrystalline thin film obtained in Example 2;
FIG. 7 shows the scintillation decay time of the microcrystalline thin film obtained in Example 1;
FIG. 8 shows an afterglow curve of the microcrystalline thin film obtained in Example 1; and
FIG. 9 shows a schematic diagram of a detector composed of the microcrystalline thin film obtained in Example 1 and a photodetector.

### DETAILED DESCRIPTION OF PREFERRED EMBODIMENTS

The present invention will be further illustrated by the following embodiments below, and it should be understood that the following embodiments are only used to illustrate the present invention rather than to limit it.

In the present disclosure, the thallium-doped low-dimensional perovskite-structured microcrystalline thin film has the following general formulas: (A_{1-a-b}A'ₐTl_{b})(B_{1-c}B'_{c})₂(X_{1-d}X'_{d})₃, (A_{1-a-b}A'ₐTl_{b})₂(B_{1-c}B'_{c})(X_{1-d}X'_{d})₃, or (A_{1-a-b}A'ₐTl_{b})₃(B_{1-c}B'_{c})₂(X_{1-d}X'_{d})₅, wherein A and A' are at least one of Li, Na, K, Rb, Cs, and In; B and B' are at least one of Cu, and Ag; X and X' are F, Cl, Br, and I; and a is greater than or equal to 0 and less than 1, b is greater than 0 and less than or equal to 1, c is greater than or equal to 0 and less than or equal to 1, and d is greater than or equal to 0 and less than or equal to 1; wherein the X-ray excited luminescence of the thallium-doped low-dimensional perovskite-structured metal halide microcrystalline scintillation thin film is 350 nm to 1200 nm.

An exemplary illustration of an operation process of preparing the thallium-doped low-dimensional perovskite-structured microcrystalline thin film by a vacuum coating method is described below.

Weighing of high-purity halide materials. High-purity halide materials are weighed according to the general formulas of the compositions ((A_{1-a-b}A'ₐTl_{b})(B_{1-c}B'_{c})₂(X_{1-d}X'_{d})₃, (A_{1-a-b}A'ₐTl_{b})₂(B_{1-c}B'_{c})(X_{1-d}X'_{d})₃, or (A_{1-a-b}A'ₐTl_{b})₃(B_{1-c}B'_{c})₂(X_{1-d}X'_{d})₅).

Synthesis of Coating Material. In an inert gas environment, all the materials are loaded into a quartz tube, the crucible temperature is increased above the melting points of the materials, so that the materials are completely melted and uniformly mixed, and after cooling, a coating material (thallium-doped low-dimensional perovskite-structured compound, thallium-free low-dimensional perovskite-structured compound and thallium halide TlX (X is F, Cl, Br, or I), or thallium-doped low-dimensional perovskite-structured compound and thallium halide TlX (X is F, Cl, Br, or I)) is synthesized. The inert gas environment may be a glove box filled with argon or nitrogen.

Cleaning and drying. A substrate made of TFT glass or other materials as a coating substrate is ultrasonically cleaned by deionized water, absolute ethanol, or acetone and dried.

Coating by thermal evaporation. The coating material of the thallium-doped low-dimensional perovskite-structured microcrystalline scintillation thin film is a dual-source coating material; the dual-source coating material is a synthesized thallium-doped low-dimensionalperovskite-structured compound and thallium halide. As an example, a clean and dry substrate is placed in a vacuum coating device, and the obtained coating material is loaded into an evaporation boat with a corresponding volume. In order to avoid asynchronous evaporation caused by great difference between the melting points of the halide material and that of TlX, an evaporation boat loaded with bead-like thallium halide may be additionally added for synchronous evaporation with the existing thallium-doped low-dimensional perovskite-structured compound. The aforementioned vacuum coating device may be vacuumized below 10⁻³ Pa, and the substrate is heated to 20 °C to 300 °C. When the vacuum degree and the temperature of the substrate become stable, current heating is started, input power is gradually adjusted until the vacuum degree decreases, the coating procedure is started, the thallium-doped low-dimensional perovskite-structured compound is heated into a molten state, and TlX is heated into a molten or nearly sublimed state. After evaporation is completed, a heating unit is turned off, and the temperature is naturally decreased to room temperature. The obtained thallium-doped low-dimensional perovskite-structured microcrystalline thin film is stored in a dry environment.

Examples will be taken to further illustrate the present invention in detail below. It should also be understood that the following examples are only used to further illustrate the present invention rather than to limit the protection scope of the present invention. All non-essential improvements and adjustments which are made by those skilled in the art according to the above contents of the present invention shall fall within the protection scope of the present invention. The specific technological parameters of the following examples are merely one example in an appropriate range, that is, those skilled in the art can make choices within the appropriate range through the description herein, but the choices are not limited to the specific values of the following examples.

### Example 1:

The chemical formula of the composition of the thallium-doped low-dimensional perovskite-structured microcrystalline thin film proposed in Example 1 is (Cs_{0.99}TI_{0.01})₃Cu₂I₅, i.e., (A_{1-a-b}A'ₐTl_{b})₃(B_{1-c}B'_{c})₂(X_{1-d}X'_{d})₅ as the general formula, with A being Cs, B being Cu, X being I, b being equal to 0.01, and a, c, and d being equal to 0.

The aforementioned thallium-doped low-dimensional perovskite-structured microcrystalline thin film was prepared by a vacuum evaporation method, and the corresponding preparation method comprises the following steps.

(Step 1) According to the molar ratio of the chemical formula ((Cs_{0.99}TI_{0.01})₃Cu₂I₅) of the composition of the thin film, high-purity materials (1.33 g of CsI, 0.66 g of CuI, and 0.017 g of TlI) with a purity of 99.99% were weighed. In an inert gas environment, all the materials were loaded into a quartz tube, and the crucible was heated above the melting points of the materials so that the materials were completely melted and uniformly mixed, and after cooling, a thallium-doped low-dimensional perovskite-structured compound material was synthesized. In Example 1, the inert gas environment was a glove box filled with argon or nitrogen.

(Step 2) A quartz glass substrate with a diameter of 50 mm as the coating substrate was ultrasonically cleaned with absolute ethanol for 10 min and dried with a hot air blower.

(Step 3) The clean and dry substrate was placed in a vacuum coating device, and 2 g of coating material was loaded into an evaporation boat with a corresponding volume. This was intended to avoid asynchronous evaporation caused by the large difference in the melting points between the halide materials and TlI. In Example 1, an evaporation boat loaded with 0.04 g of bead-like TlI was additionally added for synchronous evaporation with existing (Cs_{0.99}TI_{0.01})₃Cu₂I₅.

(Step 4) The vacuum coating device was vacuumized to 10⁻⁴ Pa, and meanwhile, the substrate was heated to 200 °C.

(Step 5) When the vacuum degree and the temperature of the substrate became stable, the current was turned to heat, the input power was gradually adjusted until the vacuum degree decreased, the coating procedure was started, (Cs_{0.99}TI_{0.01})₃Cu₂I₅ was heated into a molten state, and bead-like TlI was heated until the TII beads turned red and black and were in a nearly sublimed state. After the evaporation was completed, a heating unit was turned off, and the temperature was naturally cooled down to room temperature. The obtained thallium-doped Cs₃Cu₂I₅ microcrystalline thin film was stored in a dry environment.

The result of an X-ray excited emission spectrum test shows that the thallium-doped Cs₃Cu₂I₅ microcrystalline thin film has strong X-ray excited luminescence, which indicates that the low-dimensional perovskite-structured microcrystalline thin film can be used in the fields of X-ray, γ-ray, and neutron detection and medical imaging, security inspection, industrial testing, etc.

### Example 2:

The chemical formula of the composition of a thallium-doped low-dimensional perovskite-structured microcrystalline thin film proposed in Example 2 is Cs_{0.99}TI_{0.01}Cu₂I₃, i.e., (A_{1-a-b}AₐTl_{b})(B_{1-c}B_{c})₂(X_{1-d}X_{d})₃ as the general formula, with A being Cs, B being Cu, X being I, b being equal to 0.01, and a, c, and d being equal to 0.

The aforementioned thallium-doped low-dimensional perovskite-structured microcrystalline thin film was prepared by adopting a vacuum evaporation method. The corresponding preparation method comprised the following steps:
(Step 1) According to the molar ratio of the chemical formula (Cs_{0.99}TI_{0.01}Cu₂I₃) of the composition of the thin film, high-purity materials (0.80 g of CsI, 1.19 g of CuI, and 0.01 g of TlI) with a purity of 99.99% were weighed. In an inert gas environment, all the materials were loaded into a quartz tube, the temperature of crucible was increased above the melting points of the materials so that the materials were completely melted and uniformly mixed, and, after cooling, a thallium-doped low-dimensional perovskite-structured compound material was synthesized. In Example 2, the inert gas environment was a glove box filled with argon.
(Step 2) A quartz glass substrate with a diameter of 50 mm as the coating substrate was ultrasonically cleaned with absolute ethanol for 10 min, and dried.
(Step 3) The clean and dry substrate was placed in a vacuum coating device, and 2 g of coating material was loaded into an evaporation boat with a corresponding volume. This was intended to avoid asynchronous evaporation caused by the large difference in the melting points between the halide materials and TlI. In Example 2, an evaporation boat loaded with 0.04 g of bead-like TlI was additionally added for synchronous evaporation with existing Cs_{0.99}TI_{0.01}Cu₂I₃.
(Step 4) The vacuum coating device was vacuumized to 10⁻⁴ Pa, and meanwhile, the substrate was heated to 200 °C.
(Step 5) When the vacuum degree and the temperature of substrate became stable, current heating was started, input power was gradually regulated until the vacuum degree decreased, the coating procedure was started, Cs_{0.99}TI_{0.01}Cu₂I₃ was heated into a molten state, and bead-like TlI was heated until the TII beads turned red and black and were in a nearly sublimed state. After evaporation was completed, a heating unit was turned off, and the temperature was naturally decreased to room temperature. The obtained thallium-doped CsCu₂I₃ microcrystalline thin film was stored in a dry environment.

The result of an X-ray excited emission spectrum test shows that the thallium-doped CsCu₂I₃ microcrystalline thin film has X-ray excited luminescence, which indicates that the low-dimensional perovskite-structured microcrystalline thin film can be used in the fields of X-ray and γ-ray detection, medical imaging, security inspection, industrial testing, etc.

### Example 3:

The chemical formula of the composition of a thallium-doped low-dimensional perovskite-structured microcrystalline thin film proposed in Example 3 is (Cs_{0.99}TI_{0.01})₂AgI₃, i.e., (A_{1-a-b}AₐTl_{d})₂(B_{1-c}B_{c})₂(X_{1-d}X_{d})₃ as the general formula, with A being Cs, B being Ag, X being I, b being equal to 0.01, and a, c, and d being equal to 0.

The aforementioned thallium-doped low-dimensional perovskite-structured microcrystalline thin film was prepared by vacuum evaporation method. The corresponding preparation method comprised the following steps.

(Step 1) According to the molar ratio of the chemical formula ((Cs_{0.99}TI_{0.01})₂AgI₃) of the composition of the thin film, high-purity materials (1.45 g of CsI, 0.54 g of AgI, and 0.013 g of TlI) with a purity of 99.99% were weighed. In an inert gas environment, all the materials were loaded into a quartz tube, the temperature of crucible was increased above the melting points of the materials so that the materials were completely melted and uniformly mixed, and, after cooling, a thallium-doped low-dimensional perovskite-structured compound material was synthesized. In Example 3, the inert gas environment was a glove box filled with argon.

(Step 2) A quartz glass substrate with a diameter of 50 mm as the coating substrate was ultrasonically cleaned with absolute ethanol for 10 min, and dried.

(Step 3) The clean and dry substrate was placed in a vacuum coating device, and 2 g of coating material was loaded into an evaporation boat with a corresponding volume. This was intended to avoid asynchronous evaporation caused by large difference in the melting points between the halide materials and TlI. In Example 3, an evaporation boat loaded with 0.04 g of bead-like TlI was additionally added for synchronous evaporation with existing (Cs_{o.99}TI_{0.01})₂AgI₃.

(Step 4) The vacuum coating device was vacuumized to 10⁻⁴ Pa, and meanwhile, the substrate was heated to 200 °C.

(Step 5) When the vacuum degree and the temperature of substrate became stable, current heating was started, input power was gradually regulated until the vacuum degree decreased, the coating procedure was started, (Cs_{0.99}TI_{0.01})₂AgI₃ was heated into a molten state, and bead-like TlI was heated until the TII beads turned red and black and were in a nearly sublimed state. After evaporation was completed, a heating unit was turned off, and the temperature was naturally decreased to room temperature. The obtained thallium-doped Cs₂AgI₃ microcrystalline thin film was stored in a dry environment.

The result of an X-ray excited emission spectrum test shows that the thallium-doped Cs₂AgI₃ microcrystalline thin film has X-ray excited luminescence, which indicates that the low-dimensional perovskite-structured microcrystalline thin film can be used in the fields of X-ray and γ-ray detection, medical imaging, security inspection, industrial testing, etc.

### Comparative Example 1:

Comparative Example 1 gives an example that does not conform to the three given general formulas, and the chemical formula of its composition is between (Cs_{0.99}TI_{0.01})₂CuI₃ and (Cs_{0.99}TI_{0.01})₃Cu₂I₅.

The aforementioned thallium-doped low-dimensional perovskite-structured microcrystalline thin film was prepared by vacuum evaporation method. The corresponding preparation method comprised the following steps.

(Step 1) Deviating from the molar ratio of the chemical formulas ((Cs_{0.99}TI_{0.01})₂CuI₃ and (Cs_{0.99}TI_{0.01})₃Cu₂I₅) of the composition of the thin film, high-purity materials (1.45 g of CsI, 0.55 g of CuI, and 0.01 g of TlI) with a purity of 99.99% were weighed. In an inert gas environment, all the materials were loaded into a quartz tube, the temperature of crucible was increased above the melting points of the materials so that the materials were completely melted and uniformly mixed, and, after cooling, a thallium-doped low-dimensional perovskite-structured compound material was synthesized. In Comparative Example 1, the inert gas environment was a glove box filled with argon.

(Step 2) A quartz glass substrate with a diameter of 50 mm as the coating substrate was ultrasonically cleaned with absolute ethanol for 10 min, and dried.

(Step 3) The clean and dry substrate was placed in a vacuum coating device, and 2 g of coating material was loaded into an evaporation boat with a corresponding volume. This was intended to avoid asynchronous evaporation caused by large difference in the melting points between the halide materials and TlI. In Comparative Example 1, an evaporation boat loaded with 0.04 g of bead-like TlI was additionally added for synchronous evaporation with the existing materials.

(Step 4) The vacuum coating device was vacuumized to 10⁻⁴ Pa, and meanwhile, the substrate was heated to 200 °C.

(Step 5) When the vacuum degree and the temperature of substrate became stable, current heating was started, input power was gradually adjusted until the vacuum degree decreased, the coating procedure was started, the materials were heated into a molten state, and bead-like TlI was heated until the TII beads turned red and black and were in a nearly sublimed state. After evaporation was completed, a heating unit was turned off, and the temperature was naturally decreased to room temperature. The obtained thallium-doped CsCu₂I₃ microcrystalline thin film was stored in a dry environment.

The result of an X-ray excited emission spectrum test shows that the aforementioned thallium-doped low-dimensional perovskite-structured microcrystalline thin film has two different X-ray excited emission peaks at the same time, exhibiting the emission of nearly white light.

Panels a and b of FIG. 1 are photos of a sample of the microcrystalline thin film obtained in Example 1 under different lights. This microcrystalline thin film is a thallium-doped Cs₃Cu₂I₅ microcrystalline thin film with a diameter of 50mm. In panel a of FIG. 1, the sample is under natural light, showing a form of pale yellow translucent film. In panel b of FIG. 1, the sample is under ultraviolet light, exhibiting bright green light emission.

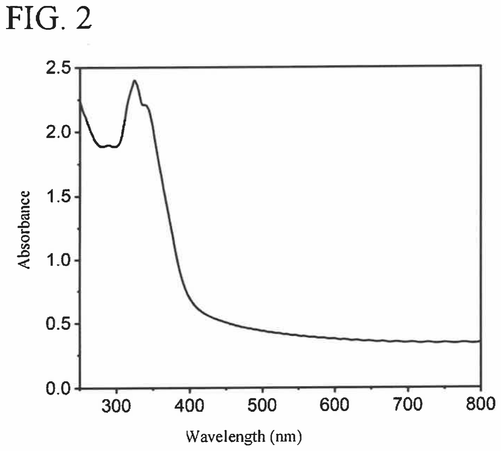

FIG. 2 shows an absorption spectrum of the microcrystalline thin film obtained in Example 1, and it can be seen that it has obvious absorption to ultraviolet light.

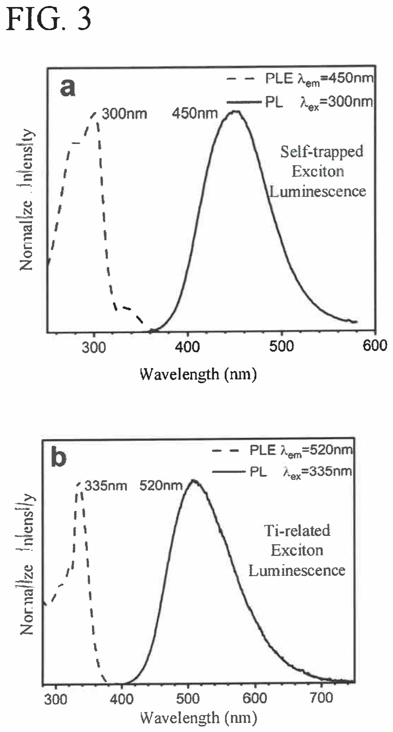

Panel a of FIG. 3 shows a fluorescence spectrum of the microcrystalline thin film obtained in Example 3 under excitation at 300 nm, and it can be seen that the thallium-doped Cs₃Cu₂I₅ microcrystalline thin film has a 450 nm emission peak corresponding to self-trapped exciton luminescence under excitation at 300 nm. Panel b of FIG. 3 shows a fluorescence spectrum of the microcrystalline thin film obtained in Example 1 under excitation at 335 nm, and it can be seen that the thallium-doped Cs₃Cu₂I₅ microcrystalline thin film has a 520 nm emission peak corresponding to Tl-related luminescence under excitation at 335 nm.

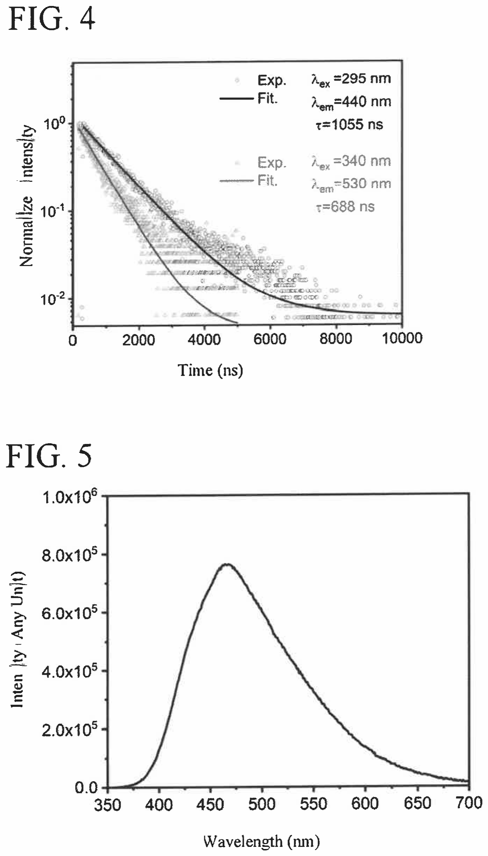

FIG. 4 shows fluorescence decay times of the two emission peaks (shown in FIG. 3) of the microcrystalline thin film obtained in Example 1, and it can be seen that the fluorescence decay time corresponding to self-trapped exciton emission is 1055 ns and that the fluorescence decay time corresponding to Tl-related emission is 688 ns.

FIG. 5 shows an X-ray excited emission spectrum of the microcrystalline thin film (thallium-doped Cs₃Cu₂I₅ microcrystalline thin film) obtained in Example 1, and the X-ray excited emission curve of the thallium-doped Cs₃Cu₂I₅ microcrystalline thin film consists of self-trapped exciton luminescence and thallium-related luminescence.

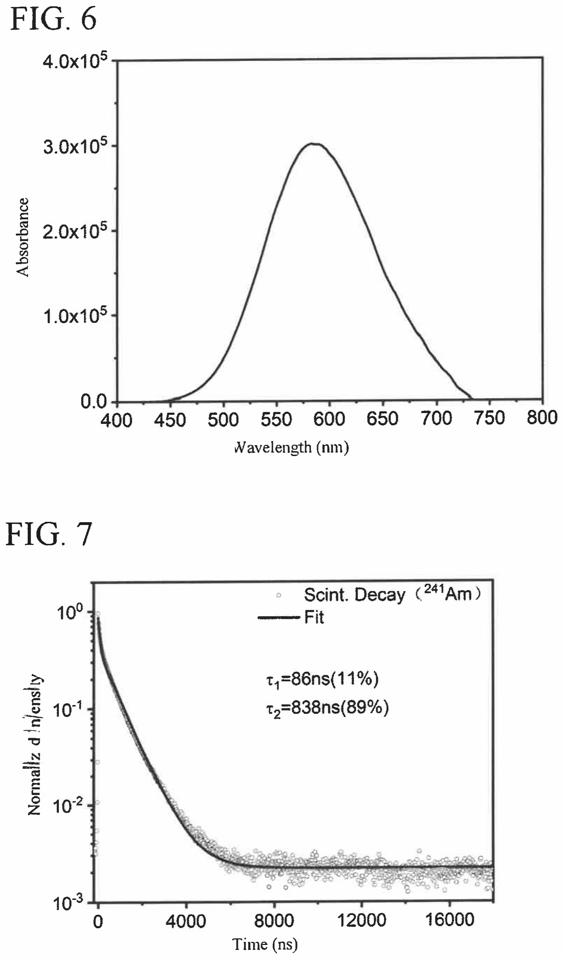

FIG. 6 shows an X-ray excited emission spectrum of the microcrystalline thin film (thallium-doped CsCu₂I₃ microcrystalline thin film) obtained in Example 2, and the X-ray excited emission curve of the thallium-doped CsCu₂I₃ microcrystalline thin film consists of self-trapped exciton luminescence and thallium-related luminescence. FIG. 7 shows the scintillation decay time of the microcrystalline thin film obtained in Example 1, showing that the scintillation decay time of the thallium-doped Cs₃Cu₂I₅ microcrystalline thin film sample can be fitted by the double-exponential function, wherein, a fast component of its decay time is 86 ns, accounting for 11%, and a slow component is 838 ns, accounting for 89%.

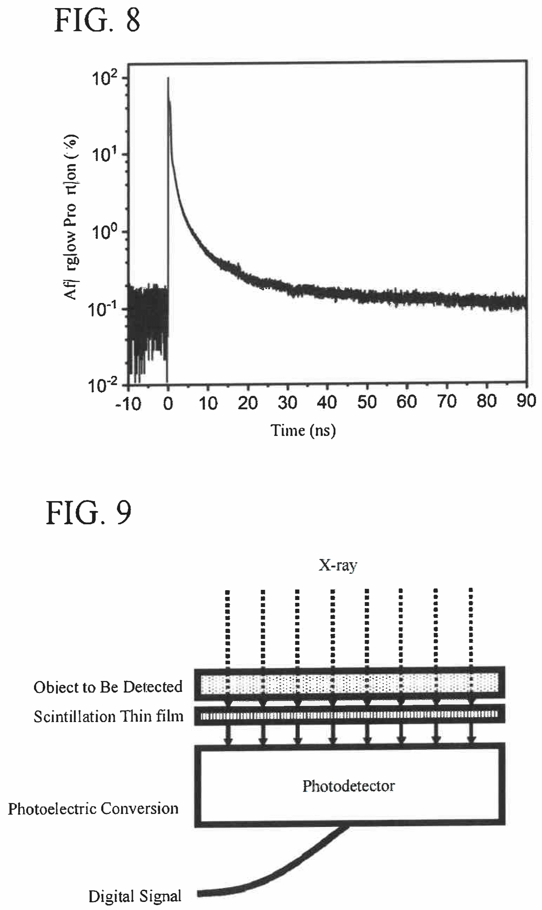

FIG. 8 shows an afterglow curve of the microcrystalline thin film obtained in Example 1, and it can be seen that the thallium-doped low-dimensional perovskite-structured thin film has a low afterglow effect.

FIG. 9 shows a schematic diagram of a detector composed of the microcrystalline thin film obtained in Example 1 and a photodetector. The operating mode of the detector is as follows: X-rays with a known intensity distribution are utilized to penetrate an object to be detected. Due to that substances with different densities and thicknesses have different X-ray absorption capacities, the intensity of the X-rays penetrating the object to be detected varies according to the densities and thicknesses of different parts of the object to be detected. After such an X-ray intensity distribution carrying the information of the object to be detected irradiates the microcrystalline thin film obtained in this example, it is converted into visible light with different intensities related to the different parts of the object to be detected. The visible light is converted into electrical signals by a photoelectric conversion device, and after information processing, a digital photo of the object to be detected is obtained.

Finally, it should also be noted that the above examples are only used to further illustrate the technical solution of the present invention in detail rather than to limit the protection scope of the present invention.

## Claims

1. A thermal evaporation method for a thallium-doped low-dimensional perovskite-structured metal halide microcrystalline scintillation thin film, wherein the general formulas of the compositions of the low-dimensional perovskite-structured metal halide are (A_{1-a-b}A'ₐTl_{b})(B_{1-c}B'_{c})₂(X_{1-d}X'_{d})₃, (A_{1-a-b}A'ₐTl_{b})₂(B_{1-c}B'_{c})(X_{1-d}X'_{d})₃ or (A_{1-a-b}A'ₐTl_{b})₃(B_{1-c}B'_{c})₂(X_{1-d}X'_{d})₅; wherein
A and A' are at least one of Li, Na, K, Rb, Cs and In;
B and B' are at least one of Cu and Ag;
X and X' are F, Cl, Br and I; and
a is greater than or equal to 0 and less than 1, b is greater than 0 and less than or equal to 1, c is greater than or equal to 0 and less than or equal to 1, and d is greater than or equal to 0 and less than or equal to 1; and
wherein the X-ray excited luminescence of the thallium-doped low-dimensional perovskite-structured metal halide microcrystalline scintillation thin film is 350 nm to 1200 nm;
the thermal evaporation method comprising:
placing a substrate into a vacuum coating device;
loading coating material into an evaporation boat with a corresponding volume;
controlling the vacuum degree and temperature of the vacuum coating device; and
starting a coating procedure;
wherien the coating material of the thallium-doped low-dimensional perovskite-structured microcrystalline scintillation thin film is a dual-source coating material; the dual-source coating material is a synthesized thallium-doped low-dimensionalperovskite-structured compound and thallium halide; and
when the coating material is loaded into the evaporation boat with the corresponding volume, an evaporation boat containing bead-like thallium halide is added to evaporate synchronously with the thallium-doped low-dimensional perovskite-structured compound; and
wherein the mass ratio of the thallium-doped low-dimensional perovskite-structured compound to thallium halide is 99.99:0.01 to 90:10.

2. The thermal evaporation method of claim 1, wherein
the general formula of the compositions of the low-dimensional perovskite-structured metal halide is (A_{1-a-b}A'ₐTl_{b})₃(B_{1-c}B'_{c})₂(X₁₋₄X'_{d})₅; and
A is Cs; B is Cu; X is I; a ,c, and d are equal to 0; and b is greater than 0 and less than or equal to 0.1.

3. The thermal evaporation method of claim 1, wherein the vacuum degree of the vacuumized vacuum coating device is lower than 10⁻² Pa, and the substrate is heated to 20 °C to 300 °C.

4. The thermal evaporation method of claim 1, wherein when the vacuum degree and the temperature of the substrate become stable, the coating procedure is started, and the coating material is heated to a molten state until the evaporation is completed.

## Patentansprüche

1. Verfahren zur thermischen Verdampfung eines Thallium-dotierten mikrokristallinen Szintillations-Dünnfilms aus Metallhalogenid mit niedrigdimensionaler Perowskit-Struktur, wobei die allgemeinen Formeln der Zusammensetzungen des Metallhalogenids mit niedrigdimensionaler Perowskit-Struktur (A_{1-a-b}A'ₐTl_{b})(B_{1-c}B'_{c})₂(X_{1-d}X'_{d})₃, (A_{1-a-b}A'ₐTl_{b})₂(B_{1-c}B'_{c})(X_{1-d}X'_{d})₃ oder (A_{1-a-b}A'ₐTl_{b})₃(B_{1-c}B'_{c})₂(X_{1-d}X'_{d})₅ sind; wobei
A und A' zumindest eines von Li, Na, K, Rb, Cs und In sind; und
B und B' zumindest eines von Cu und Ag sind;
X und X' F, Cl, Br und I sind; und
a größer oder gleich 0 und kleiner als 1 ist, b größer als 0 und kleiner oder gleich 1 ist, c größer oder gleich 0 und kleiner oder gleich 1 ist, und d größer oder gleich 0 und kleiner oder gleich 1 ist; und
wobei die durch Röntgenstrahlen angeregte Lumineszenz des Thallium-dotierten mikrokristallinen Szintillations-Dünnfilms mit niedrigdimensionaler Perowskit-Struktur 350 nm bis 1200 nm beträgt;
das Verfahren zur thermischen Verdampfung Folgendes umfasst:
Platzieren eines Substrats in einer Vakuumbeschichtungsvorrichtung;
Laden von Beschichtungsmaterial in ein Verdampfungsgefäß mit einem entsprechenden Volumen;
Steuern des Vakuumgrades und der Temperatur der Vakuumbeschichtungsvorrichtung; und
Beginnen eines Beschichtungsvorgangs;
wobei es sich bei dem Beschichtungsmaterial des Thallium-dotierten mikrokristallinen Szintillations-Dünnfilms mit niedrigdimensionaler Perowskit-Struktur um ein Dual-Quellen-Beschichtungsmaterial handelt; und wobei es sich bei dem Dual-Quellen-Beschichtungsmaterial um eine synthetisierte Thallium-dotierte Verbindung mit niedrigdimensionaler Perowskit-Struktur und Thalliumhalogenid handelt; und
wenn das Beschichtungsmaterial in das Verdampfungsgefäß mit dem entsprechenden Volumen geladen wird, ein Verdampfungsgefäß, das perlenartiges Thalliumhalogenid enthält, hinzugefügt wird, damit eine synchrone Verdampfung mit der Thallium-dotierten Verbindung mit niedrigdimensionaler Perowskit-Struktur erfolgt; und
wobei das Massenverhältnis der Thallium-dotierten Verbindung mit niedrigdimensionaler Perowskit-Struktur zu Thalliumhalogenid 99,99 : 0,01 bis 90 : 10 beträgt.

2. Verfahren zur thermischen Verdampfung nach Anspruch 1, wobei
die allgemeine Formel der Zusammensetzungen des Metallhalogenids mit niedrigdimensionaler Perowskit-Struktur (A_{1-a-b}A'ₐTl_{b})₃(B_{1-c}B'_{c})₂(X_{1-d}X'_{d})₅ ist; und
A Cs ist, B Cu ist, X I ist, a, c und d gleich 0 sind und b größer als 0 und kleiner oder gleich 0,1 ist.

3. Verfahren zur thermischen Verdampfung nach Anspruch 1, wobei der Vakuumgrad der unter Vakuum stehenden Vakuumbeschichtungsvorrichtung kleiner als 10⁻² Pa ist und das Substrat auf 20 °C bis 300 °C erhitzt wird.

4. Verfahren zur thermischen Verdampfung nach Anspruch 1, wobei, wenn der Vakuumgrad und die Temperatur des Substrats stabil werden, der Beschichtungsvorgang begonnen wird und das Beschichtungsmaterial bis zur Beendigung der Verdampfung in einen geschmolzenen Zustand erhitzt wird.

## Revendications

1. Procédé d'évaporation thermique pour un film mince microcristallin scintillant à base d'halogénure métallique à structure pérovskite de basse dimensionnalité dopé au thallium, dans lequel les formules générales des compositions de l'halogénure métallique à structure pérovskite de basse dimensionnalité sont (A_{1-a-b}A'ₐTl_{b})(B_{1-c}B'_{c})₂(X_{1-d}X'_{d})₃, (A_{1-a-b}A'ₐTl_{b})₂(B_{1-c}B'_{c})(X_{1-d}X'_{d})₃ et (A_{1-a-b}A'ₐTl_{b})₃(B_{1-c}B'_{c})₂(X_{1-d}X'_{d})₅,
A et A' représentent au moins un élément parmi Li, Na, K, Rb, Cs et In,
B et B' représentent au moins un élément parmi Cu et Ag,
X et X' représentent F, Cl, Br et I, et
a est supérieur ou égal à 0 et inférieur à 1, b est supérieur à 0 et inférieur ou égal à 1, c est supérieur ou égal à 0 et inférieur ou égal à 1, et d est supérieur ou égal à 0 et inférieur ou égal à 1 ;
la fluorescence X du film mince microcristallin scintillant à structure pérovskite de basse dimensionnalité dopé au thallium allant de 350 nm à 1200 nm ;
le procédé d'évaporation thermique comprenant :
la mise en place d'un substrat dans un dispositif de revêtement sous vide,
le chargement du matériau de revêtement dans un creuset d'évaporation d'un volume correspondant,
la régulation du degré de vide et de la température du dispositif de revêtement sous vide, et
le démarrage d'une procédure de revêtement ;
ledit matériau de revêtement du film mince microcristallin scintillant à structure pérovskite de basse dimensionnalité dopé au thallium étant un matériau de revêtement à double source ; le matériau de revêtement à double source étant un composé synthétisé à structure pérovskite de basse dimensionnalité dopé au thallium et un halogénure de thallium ; et
lorsque le matériau de revêtement est chargé dans le creuset d'évaporation de volume correspondant, il est ajouté un creuset d'évaporation contenant de l'halogénure de thallium en forme de billes destiné à s'évaporer simultanément avec le composé à structure pérovskite de basse dimensionnalité dopé au thallium ; et
le rapport massique entre le composé à structure pérovskite de basse dimensionnalité dopé au thallium et l'halogénure de thallium va de 99,99:0,01 à 90:10.

2. Procédé d'évaporation thermique selon la revendication 1, dans lequel
la formule générale des compositions de l'halogénure métallique à structure pérovskite de basse dimensionnalité est (A_{1-a-b}A'ₐTl_{b})₃(B_{1-c}B'_{c})₂(X_{1-d}X'_{d})₅ ; et A représente Cs, B représente Cu, X représente I, a, c et d sont égaux à 0, et b est supérieur à 0 et inférieur ou égal à 0,1.

3. Procédé d'évaporation thermique selon la revendication 1, dans lequel le degré de vide du dispositif de revêtement sous vide est inférieur à 10⁻² Pa et le substrat est chauffé à une température de 20 °C à 300 °C.

4. Procédé d'évaporation thermique selon la revendication 1, dans lequel, lorsque le degré de vide et la température du substrat deviennent stables, la procédure de revêtement est démarrée et le matériau de revêtement est chauffé à l'état fondu jusqu'à ce que l'évaporation soit totale.
